# FASCICULE DE BREVET EUROPEEN

(11) **EP 2 966 454 B1**
(45) Date de publication et mention de la délivrance du brevet: **30.08.2017**
(21) Numéro de dépôt: 14175967.0
(22) Date de dépôt: 07.07.2014
(51) Int. Cl.: G01C 19/5776, G01P 15/12, G01P 15/18, G01D 5/16, G01L 1/22

(54) **Procédé de mesure d'un paramètre physique, et circuit électronique pour sa mise en oeuvre**
Verfahren zum Messen eines physikalischen Parameters, und elektronischer Schaltkreis zu dessen Umsetzung
Method for measuring a physical parameter, and electronic circuit for implementing same

(43) Date de publication de la demande: 13.01.2016
(73) Titulaire: EM Microelectronic-Marin SA, 2074 Marin (CH)
(72) Inventeur: Deschildre, Alexandre, 2074 Marin (CH); Grosjean, Sylvain, 25500 Les Fins (FR)
(74) Mandataire: Giraud, Eric

(56) Documents cités:
- US-A- 5 726 480
- US-A1- 2013 088 247

## Description

L'invention concerne un procédé de mesure d'un paramètre physique, tel qu'une accélération ou une vitesse angulaire ou une pression ou une force.

L'invention concerne également un circuit électronique pour la mise en oeuvre du procédé de mesure du paramètre physique.

Traditionnellement pour la mesure d'un paramètre physique, tel qu'une accélération ou une vitesse angulaire, le circuit électronique comprend un capteur capacitif connecté à une interface électronique susceptible de fournir au moins un signal de mesure en sortie. Le capteur capacitif est composé de deux condensateurs montés en différentiel, dont l'électrode commune est mobile et fait partie d'une armature maintenue élastiquement entre les deux électrodes fixes.

Avec ce capteur à condensateurs différentiels, il est possible d'effectuer une mesure selon une direction de mouvement de l'électrode mobile. Au repos, cette électrode commune mobile se trouve à égale distance de l'une et de l'autre électrode fixe pour avoir des capacités de valeur égale des deux condensateurs. L'électrode commune mobile peut se déplacer d'une certaine distance en direction de l'une ou l'autre des électrodes fixes sous l'action notamment d'une force. Ainsi la valeur capacitive de chaque condensateur varie inversement. Le circuit électronique permet ainsi de fournir généralement un signal de mesure analogique en sortie. Ce signal de sortie analogique est défini sous la forme d'une tension dépendant de la variation des capacités des deux condensateurs.

Le capteur capacitif peut être un accéléromètre uniaxe avec les deux condensateurs différentiels pour effectuer une mesure d'accélération en liaison avec l'interface électronique. Cependant il peut aussi être prévu trois paires de condensateurs différentiels pour un tel capteur capacitif, tel qu'un accéléromètre triaxial du type MEMS pour effectuer une mesure dans les trois directions X, Y et Z. Un tel accéléromètre triaxial du type MEMS peut comprendre une masse unique, c'est-à-dire une masse inertielle commune aux trois paires de condensateurs différentiels, ou trois masses pour les trois paires de condensateurs.

L'interface électronique et le capteur capacitif sont généralement réalisés chacun dans un substrat semi-conducteur. Ainsi, des capacités parasites s'ajoutent aux capacités des condensateurs du capteur capacitif MEMS, ce qui crée des non-linéarités et également une diminution de la sensibilité ou du gain du circuit électronique. Avec les capacités parasites du capteur capacitif MEMS et celles de l'interface électronique, cela conduit à une variation de la force réelle mesurée, ce qui est un inconvénient.

Dans le document de brevet EP 2 343 507, il est décrit un circuit électronique à capteur de mesure uniaxe ou triaxial. Un traitement numérique des signaux de mesure est effectué à la suite d'un amplificateur à transfert de charges dans une unité logique. Des signaux numériques de mesure suite à une polarisation positive et à une polarisation négative du capteur capacitif sont mémorisés dans des registres correspondants de l'unité logique. Un convertisseur numérique-analogique est également utilisé pour convertir les signaux numériques successivement pour chaque axe dans un cycle de mesure, en une tension à appliquer aux électrodes du capteur par l'intermédiaire d'une unité de commutation. Grâce à la combinaison des signaux numériques de mesure suite aux polarisations positive et négative, cela permet de réduire l'effet des capacités parasites.

Pour obtenir des valeurs finales de mesure de l'accélération pour chaque axe, il est utilisé dans l'unité logique, un algorithme par dichotomie pour un certain nombre de cycles de mesure, avant de terminer par des étapes de sur-échantillonnage. Avec cet algorithme par dichotomie, la mesure débute toujours, lors de chaque conversion, à la moitié de la marge en tension de mesure. Si une erreur survient lors de la première mesure avec un grand pas de changement dans l'unité logique, la valeur finale au terme de tous les cycles de mesure, sera inévitablement fausse, ce qui constitue un inconvénient.

De plus avec un tel circuit électronique à capteur capacitif, il doit toujours être opéré pour chaque cycle de mesure une phase de polarisation des électrodes, suivie par une phase de décharge des électrodes des condensateurs par la tension de mesure du convertisseur. De ce fait avec une polarisation positive et une polarisation négative, il doit donc être prévu quatre phases par cycle de mesure. Cela ralentit la fourniture des signaux numériques de mesure au terme de chaque conversion, ce qui constitue un autre inconvénient.

On peut citer le document de brevet US 2013/0088247 A1, qui décrit un dispositif de mesure avec un réseau de capteurs de pression à résistance variable. Le dispositif de mesure comprend un circuit de commutation relié aux capteurs de pression, un circuit de mesure et une unité de commande pour commander la commutation pour la sélection d'un capteur cible du réseau. Une mesure est relativement compliquée avec ce dispositif de mesure et ne concerne pas une mesure d'une accélération.

Dans le document de brevet US 5,726,480 A, il est décrit la réalisation d'un accéléromètre, qui utilise de faibles masses liées à des piézo-résistances pour la mesure. Un usinage d'un substrat en silicium est effectué pour réaliser des structures tridimensionnelles de l'accéléromètre avec les piézo-résistances sur des bras support. Les piézo-résistances sont reliées électriquement dans la configuration d'un pont de Wheastone pour la mesure de l'accélération. Cependant aucune information relative à la manière d'opérer une mesure avec l'accéléromètre n'est mentionnée.

L'invention a donc pour but de pallier aux inconvénients de l'état de la technique susmentionnés en fournissant un procédé de mesure d'un paramètre physique au moyen d'un circuit électronique, qui permet de fournir rapidement au moins un signal de mesure numérique tout en supprimant les effets des capacités parasites.

A cet effet, l'invention concerne un procédé de mesure d'un paramètre physique au moyen d'un circuit électronique à capteur résistif, qui comprend les caractéristiques définies dans les revendications indépendantes 1 et 2.

Des étapes particulières du procédé de mesure sont définies dans les revendications dépendantes 3 à 7.

Un avantage du procédé de mesure réside dans le fait qu'uniquement deux phases par cycle de mesure sont suffisantes pour opérer la mesure du paramètre physique. Dans une première phase, une polarisation positive peut être effectuée sur le capteur résistif, et dans une seconde phase successive une polarisation négative peut être effectuée sur ledit capteur résistif. Un certain nombre de cycles de mesure avec les phases successives de polarisation positive et de polarisation négative, est prévu pour une conversion de mesure, afin de fournir au moins un signal numérique de sortie au terme de la conversion par l'unité logique.

Avantageusement les tensions appliquées sur le capteur résistif du type MEMS pour la polarisation positive et la polarisation négative, sont bien contrôlées. Ce contrôle des tensions est effectué par l'intermédiaire d'un convertisseur numérique-analogique fonctionnant à pleine échelle et relié à l'unité logique et à un générateur de tension de référence à gain programmable. Grâce à ce contrôle des tensions, il est possible de limiter le courant passant à travers chaque résistance.

Avantageusement en effectuant des cycles de mesure successifs avec des polarisations positive et négative sur le capteur résistif, cela permet de supprimer les offsets liés au capteur du type MEMS et à l'interface électronique reliée au capteur, ainsi que le bruit à faible fréquence.

Il peut aussi avantageusement être prévu une interface ratio-métrique pour avoir un bon rapport de rejection de la tension d'alimentation continue et à faible fréquence.

Avantageusement pour le procédé de mesure, il y a une grande flexibilité de fonctionnement de l'algorithme implanté dans l'unité logique. Un tel algorithme intelligent permet d'avoir un grand rapport de sur-échantillonnage, grâce à des petits pas d'adaptation de chaque signal numérique de mesure pour le convertisseur, et une grande réactivité, grâce à de grands pas d'adaptation de chaque signal numérique de mesure pour le convertisseur.

Pour ce faire, le procédé de mesure utilise avantageusement un algorithme auto-adaptatif pour détecter de grands changements du paramètre physique et ceci notamment entre deux conversions successives ou dans une même conversion. Après un certain nombre de cycles de mesure à petits pas, un compteur de décisions détermine si une augmentation continuelle ou une diminution continuelle des signaux numériques, intervient, afin d'adapter la taille de chaque pas des cycles de mesure subséquents. L'adaptation à une grande valeur numérique de chaque pas intervient, dès qu'un seuil prédéterminé de comptage d'un compteur de décisions est dépassé. Dès que le compteur de décisions détermine un changement de signe dans les cycles de mesure à grande valeur de pas, la taille des pas de chaque cycle de mesure est réadaptée à de petits pas pour réduire le bruit.

Avantageusement pour le procédé de mesure, le dernier signal numérique mémorisé de chaque registre correspondant, au terme de chaque conversion, peut permettre de débuter une conversion de mesure subséquente. Pour débuter une nouvelle conversion, il peut également être utilisé une moyenne finale des signaux numériques successifs stockés dans un registre correspondant dans au moins une partie finale de cycles successifs de mesure à petits pas d'adaptation. Une sélection de la dernière valeur numérique stockée de chaque signal numérique ou de la moyenne des signaux numériques dans la partie finale de cycles de mesure, peut être effectuée sur la base d'un comptage par le compteur de décisions.

A cet effet, l'invention concerne également un circuit électronique à capteur résistif pour la mise en oeuvre du procédé de mesure, qui comprend les caractéristiques définies dans les revendications indépendantes 8 et 9.

Des formes d'exécution spécifiques du circuit électronique sont définies dans les revendications dépendantes 10 à 14.

Un avantage du circuit électronique d'interface d'un capteur physique réside dans le fait qu'il permet d'obtenir rapidement au moins un signal de mesure en sortie de l'unité logique, car le capteur résistif est successivement polarisé selon une polarisation positive suivie par une polarisation négative. L'unité logique est à même de mettre en fonction d'un algorithme auto-adaptatif mémorisé pour adapter la taille des pas d'adaptation des cycles de mesure pour fournir des signaux numériques adaptés en fonction d'une détection d'un grand changement du paramètre physique mesuré durant une conversion de mesure. Deux signaux numériques dépendant d'une polarisation positive ou première polarisation, et d'une polarisation négative ou seconde polarisation des électrodes fixes de la paire de condensateurs, sont généralement fournis dans l'unité logique. Ceci permet par combinaison des signaux numériques de supprimer tout écart de tension notamment des composants du circuit électronique.

Les buts, avantages et caractéristiques du procédé de mesure d'un paramètre physique et le circuit électronique à capteur résistif pour sa mise en oeuvre apparaîtront mieux dans la description suivante en regard des dessins sur lesquels :
- la figure 1 représente de manière simplifiée une première forme d'exécution d'un circuit électronique à capteur résistif pour la mise en oeuvre du procédé de mesure d'un paramètre physique selon l'invention,
- la figure 2 représente de manière simplifiée une seconde forme d'exécution d'un circuit électronique à capteur résistif pour la mise en oeuvre du procédé de mesure d'un paramètre physique selon l'invention, et
- la figure 3 représente une forme d'exécution du convertisseur numérique-analogique DAC avec une unité de génération de tension de référence à gain programmable du circuit électronique selon l'invention.

Dans la description suivante comme différents composants du circuit électronique à capteur résistif sont bien connus dans ce domaine technique, ils ne seront pas tous explicités en détail. L'accent porte principalement sur le procédé de mesure du paramètre physique par un circuit électronique, qui fournit un ou plusieurs signaux numériques de mesure en sortie.

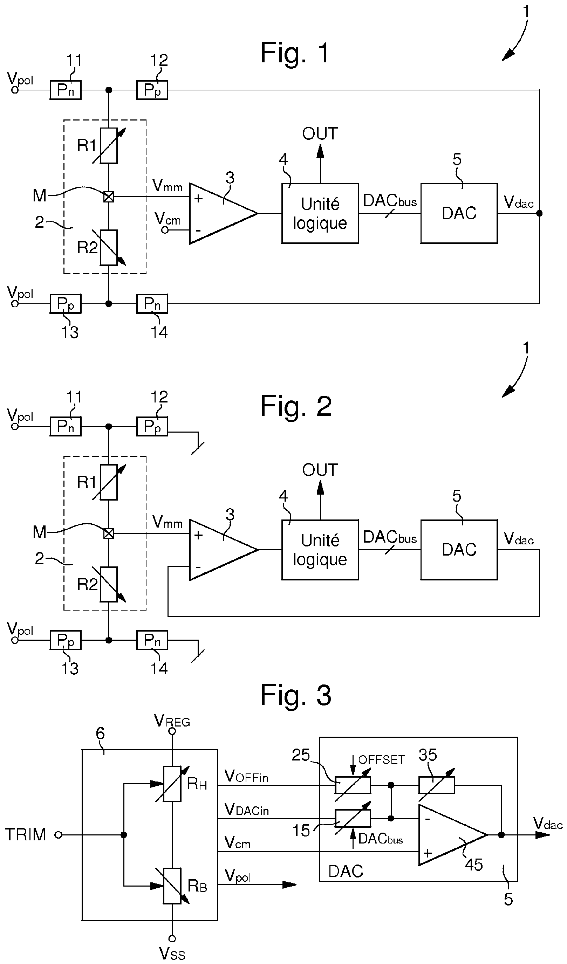

La figure 1 montre un schéma simplifié d'une première forme d'exécution du circuit électronique à capteur résistif 2 pour une mesure d'un paramètre physique, tel qu'une accélération ou une vitesse angulaire, voire une pression ou une force selon au moins une direction. Le capteur résistif 2 est composé d'un diviseur résistif avec deux résistances R1 et R2, qui sont connectées en série. Comme expliqué ci-après chaque résistance R1 et R2 est une jauge de contrainte à valeur résistive variable en fonction du déplacement d'une masse mobile M dans une structure fixe du capteur résistif de type MEMS. La masse mobile M est disposée au noeud de connexion des résistances R1, R2 et se déplace en fonction de l'accélération ou la vitesse angulaire à mesurer.

Un noeud de connexion des résistances R1, R2 est relié à une première entrée d'un amplificateur-comparateur 3, qui fait partie d'une interface électronique liée au capteur résistif 2 de type MEMS. La première entrée de l'amplificateur-comparateur est de préférence l'entrée positive, alors qu'une seconde entrée, qui est de préférence l'entrée négative, reçoit une tension de référence, qui est une tension définie en mode commun V_{cm}. Cette tension en mode commun est de préférence déterminée à une valeur correspondant à la moitié de la tension régulée V_{REG} d'alimentation du circuit électronique 1, c'est-à-dire à V_{REG}/2. Une comparaison est opérée entre la tension en mode commun V_{cm} et la tension Vₘₘ au noeud de connexion des résistances pour fournir un signal, qui est de préférence une tension de comparaison en sortie de l'amplificateur-comparateur à une unité logique 4.

L'unité logique 4 comprend des moyens de mémorisation, dans lesquels sont mémorisés notamment différents paramètres de configuration, et principalement l'algorithme de mesure du procédé selon l'invention expliqué ci-après. Différents algorithmes peuvent être choisis pour effectuer le procédé de mesure du paramètre physique en changeant la logique de l'unité logique 4. De préférence, il est choisi d'utiliser un algorithme auto-adaptatif comme expliqué ci-après. L'unité logique 4 comprend encore un processeur non représenté, qui est cadencé par un signal d'horloge traditionnel. Le processeur permet de contrôler l'exécution de toutes les étapes nécessaires du procédé de mesure d'un paramètre physique, notamment d'une accélération ou d'une vitesse angulaire.

En fonction de la tension de comparaison comp_out fournie par l'amplificateur-comparateur 3, un traitement est effectué dans l'unité logique 4 pour stocker des signaux numériques sous forme de mots binaires de mesure dans au moins deux registres. Le signal de sortie de l'amplificateur-comparateur peut être considéré comme un signal numérique pour opérer un incrément ou décrément d'un ou plusieurs pas dans l'unité logique 4 pour générer les signaux numériques de mesure. Les signaux numériques stockés dans les deux registres sont obtenus suite à une polarisation définie positive et à une polarisation définie négative du capteur résistif 2 dans chaque cycle de mesure comme expliqué ci-après. Un premier registre stocke les signaux numériques suite à une polarisation positive, alors qu'un second registre stocke les signaux numériques suite à une polarisation négative. Une combinaison des signaux numériques des deux registres peut être effectuée dans ladite unité logique 4 pour fournir au moins un signal numérique de sortie OUT au terme d'une conversion de mesure après un certain nombre de cycles de mesure.

Chaque signal numérique de mesure ou mot binaire DAC_{bus} stocké dans les deux registres de l'unité logique 4 est fourni successivement dans chaque phase de cycles de mesure au convertisseur numérique-analogique DAC 5. Ce convertisseur numérique-analogique 5 permet de convertir chaque mot binaire DAC_{bus} en une tension de mesure ou de sortie V_{dac} à fournir en contre-réaction au capteur résistif 2 par l'intermédiaire d'une unité de commutation. Une tension de mesure ou de sortie V_{dacp} est fournie suite à une polarisation positive du capteur résistif 2 et une tension de mesure ou de sortie V_{dacn} est fournie suite à une polarisation négative.

Cette unité de commutation comprend quatre commutateurs 11, 12, 13, 14, qui peuvent être formés de transistors MOS traditionnels commandés chacun sur leur grille par un signal de commande respectif. Le premier commutateur 11 est disposé entre une source de tension de polarisation Vₚₒₗ et une extrémité libre de la première résistance R1. Le second commutateur 12 est disposé entre la sortie du convertisseur analogique-numérique 5 et l'extrémité libre de la première résistance R1. Le troisième commutateur 13 est disposé entre la source de tension de polarisation Vₚₒₗ et une extrémité libre de la seconde résistance R2. Finalement le quatrième commutateur 14 est disposé entre la sortie du convertisseur analogique-numérique 5 et l'extrémité libre de la seconde résistance R2.

Comme il sera expliqué plus en détail ci-après, le procédé de mesure du paramètre physique comprend pour un cycle de mesure, une première phase de polarisation du capteur résistif 2, suivie par une seconde phase de polarisation du capteur résistif 2. Uniquement deux phases sont nécessaires par cycle de mesure avec le capteur résistif 2. Cela réduit le temps pour la fourniture d'une mesure par rapport à un procédé de mesure par un circuit électronique à capteur capacitif, pour lequel il doit encore être ajouté deux phases de décharge des condensateurs pour un total de quatre phases par cycle de mesure. La première phase de polarisation est une phase définie comme une polarisation positive, alors que la seconde phase de polarisation est une phase définie comme une polarisation négative. Bien entendu, pour chaque cycle de mesure, il peut être envisagé de commencer par une phase de polarisation négative avant une phase de polarisation positive.

Dans la première phase de polarisation positive, le second commutateur 12 et le troisième commutateur 13 sont commandés respectivement par un premier signal de commande Pₚ pour être dans un état fermé, alors que le premier commutateur 11 et le quatrième commutateur 14 sont dans un état ouvert. Ainsi, l'extrémité libre de la première résistance R1 est reliée à la sortie du convertisseur analogique-numérique 5, qui fournit une tension de sortie V_{dac} de la polarisation positive (V_{dacp}), et l'extrémité libre de la seconde résistance R2 est reliée à la source de tension de polarisation Vₚₒₗ.

Dans une seconde phase de polarisation négative, le premier commutateur 11 et le quatrième commutateur 14 sont commandés respectivement par un second signal de commande Pₙ pour être dans un état fermé, alors que le second commutateur 12 et le troisième commutateur 13 sont dans un état ouvert. Ainsi, l'extrémité libre de la seconde résistance R2 est reliée à la sortie du convertisseur analogique-numérique 5, qui fournit une tension de sortie V_{dac} de la polarisation négative (V_{dacn}), et l'extrémité libre de la première résistance R1 est reliée à la source de tension de polarisation Vₚₒₗ.

Dans la première phase de polarisation positive Pₚ, la tension de sortie du convertisseur suite à la polarisation positive V_{dacp} est appliquée à l'extrémité libre de la première résistance R1. Cette tension de sortie V_{dacp} est égale à V_{cm} + α·V_{REG} + dacp·dac_step, où V_{cm} vaut la moitié de la tension régulée V_{REG}, α est un facteur d'adaptation de tension, dacp provient du mot binaire DAC_{bus} du premier registre de l'unité logique 4, et dac_step est une valeur de pas exprimée en Volt/code. La tension appliquée à l'extrémité libre de la seconde résistance R2 est la tension de polarisation Vₚₒₗ, qui peut être égale à V_{REG}/2 ± α·V_{REG}. Ainsi la tension Vₘₘ au noeud de connexion des résistances R1 et R2 et fournie à la première entrée de l'amplificateur-comparateur 3, est égale à Vₚₒₗ·(R1/(R1 + R2)) + V_{dacp}·(R2/(R1 + R2)).

Si la tension Vₘₘ est plus grande que V_{cm}, alors le signal de sortie comp_out de l'amplificateur-comparateur 3 est à l'état "1" par exemple proche de la tension régulée V_{REG}. Le mot binaire dacp du premier registre peut être diminué d'un certain nombre de pas. Par contre si la tension Vₘₘ est plus petite que V_{cm}, alors le signal de sortie comp_out de l'amplificateur-comparateur 3 est à l'état "0". Dans ce cas, le mot binaire dacp du premier registre peut être augmenté d'un certain nombre de pas.

Dans la seconde phase de polarisation négative Pₙ, la tension de sortie du convertisseur suite à la polarisation négative V_{dacn} est appliquée à l'extrémité libre de la seconde résistance R2. Cette tension de sortie V_{dacn} est égale à V_{cm} + α·V_{REG} + dacn·dac_step, où V_{cm} vaut la moitié de la tension régulée V_{REG}, α est un facteur d'adaptation de tension, dacn provient du mot binaire DAC_{bus} du second registre de l'unité logique 4, et dac_step est une valeur de pas exprimée en Volt/code. La tension appliquée à l'extrémité libre de la première résistance R1 est la tension de polarisation Vₚₒₗ, qui peut être égale à V_{REG}/2 ± α·V_{REG}. Ainsi la tension Vₘₘ au noeud de connexion des résistances R1 et R2 et fournie à la première entrée de l'amplificateur-comparateur 3, est égale à Vₚₒₗ·(R2/(R1 + R2)) + V_{dacn}·(R1/(R1 + R2)).

Si la tension Vₘₘ est plus grande que V_{cm}, alors le signal de sortie comp_out de l'amplificateur-comparateur 3 est à l'état "1" par exemple proche de la tension régulée V_{REG}. Le mot binaire dacn du second registre peut être diminué d'un certain nombre de pas. Par contre si la tension Vₘₘ est plus petite que V_{cm}, alors le signal de sortie comp_out de l'amplificateur-comparateur 3 est à l'état "0". Dans ce cas, le mot binaire dacn du second registre peut être augmenté d'un certain nombre de pas.

Comme susmentionné, uniquement deux phases sont nécessaires par cycle de mesure avec le capteur résistif 2, pour réduire le temps pour la fourniture d'une mesure par rapport à un procédé de mesure d'un circuit électronique à capteur capacitif. Pour le procédé de mesure d'un paramètre physique selon l'invention, chaque phase peut être d'une durée de l'ordre de 2 µs, donc 4 µs par cycle de mesure. Il doit être compté environ 40 cycles de mesure pour une conversion de mesure, qui est donc d'une durée de l'ordre de 160 µs. Au terme de la conversion, la tension Vₘₘ va être proche ou égale à la tension V_{cm}.

Il est encore à noter que grâce à l'alternance de phases de polarisation positive et de polarisation négative, cela permet d'avoir une meilleure suppression de l'offset du circuit électronique 1, ainsi que du bruit à faible fréquence. De plus chaque conversion successive débute de préférence avec la fourniture depuis l'unité logique 4, du mot binaire du premier registre et du mot binaire du second registre de la précédente conversion.

Comme préalablement décrit, le capteur résistif 2 du type MEMS est composé d'un diviseur résistif R1 et R2 ou pont résistif, dont le noeud de connexion est relié mécaniquement à la masse M. Une première extrémité libre de la première résistance R1 et une seconde extrémité libre de la seconde résistance R2 sont mécaniquement reliées dans une structure fixe du capteur résistif 2. Les première et seconde résistances R1, R2 sont donc des jauges de contraintes sous forme de fils métalliques de taille nanométrique. Ces fils métalliques sont de préférence disposés dans la structure fixe selon une même droite. Ces deux résistances R1, R2 peuvent avoir une même valeur résistive au repos, mais avec une valeur résistive variant inversement lors de la mesure de l'accélération ou de la vitesse angulaire, c'est-à-dire qu'une résistance est tirée, quand l'autre est compressée, et inversement.

A titre d'exemple non limitatif, le diamètre du fil métallique de chaque résistance peut être de l'ordre de 250 nm, et d'une longueur telle que chaque résistance R1, R2 peut avoir une valeur résistive au repos de l'ordre de 3 kOhms. On peut constater une variation résistive de 3 Ohms pour 1 g d'accélération par une telle construction du capteur résistif 2. Avec de telles résistances réalisées avec des fils métalliques de taille nanométrique, le courant traversant chaque résistance doit être réduit, c'est-à-dire être contrôlé inférieur à 100 µA. Dans ces conditions, la tension de polarisation Vₚₒₗ fournie depuis la source de tension de polarisation doit être relativement faible. Cette tension de polarisation Vₚₒₗ peut être égale à V_{REG}/2 ± α·V_{REG}, où V_{REG} est la tension régulée pour l'alimentation du circuit électronique 1 et α est un facteur d'adaptation de tension. La tension régulée peut être fixée à 1.65 V. La tension de polarisation Vₚₒₗ peut être obtenue par l'intermédiaire d'un autre diviseur résistif relié à la tension régulée ou par n'importe quelle autre structure ratio-métrique.

Pour le procédé de mesure d'un paramètre physique au moyen d'un circuit électronique 1 à capteur résistif 2 décrit ci-devant, ledit capteur résistif ne comporte qu'un seul diviseur résistif pour une mesure selon une seule direction. Toutefois, il peut être concevable de prévoir un capteur résistif 2 pour deux ou trois axes X, Y et Z de mesure avec trois diviseurs résistifs, dont préférentiellement les noeuds de connexion de chaque paire de résistances sont reliées à une même masse mobile M et à la même première entrée de l'amplificateur-comparateur 3.

Pour une mesure selon trois axes X, Y et Z, l'unité de commutation doit comporter 3 fois quatre commutateurs commandés respectivement par des premier et second signaux de commande respectifs pour une polarisation positive et une polarisation négative de chaque diviseur résistif du capteur résistif 2. Il doit encore être prévu six registres dans l'unité logique 4 pour mémoriser les signaux numériques de chaque axe suite à la polarisation positive et à la polarisation négative du capteur résistif 2.

Pour le procédé de mesure, il peut être effectué pour un cycle de mesure, la polarisation positive successive de chaque diviseur résistif, suivi de la polarisation négative successive de chaque diviseur résistif avec un entrelacement des mesures selon les trois axes. Toutefois pour une mesure avec un tel capteur résistif 2, il est préférable d'effectuer toute la conversion de mesure pour un premier axe X avant de débuter la conversion de mesure pour un second axe Y et enfin pour un troisième axe Z. Ceci se différencie d'un procédé de mesure au moyen d'un circuit électronique à capteur capacitif, dans lequel il doit toujours être prévu d'effectuer une phase de décharge des condensateurs, qui n'est pas nécessaire pour un capteur résistif 2. Comme susmentionné, il doit être compté une durée de l'ordre de 3 fois 160 µs pour une conversion de mesure totale avec les trois axes de mesure du capteur résistif 2.

Un algorithme auto-adaptatif peut être exécuté notamment dans l'unité logique 4 du circuit électronique 1 pour le procédé de mesure du paramètre physique, comme décrit également dans la demande de brevet EP 2 618 163 A1. Pour ce faire, l'unité logique 4 peut comprendre au moins un compteur de décisions relié au processeur, et au moins deux registres pour un axe de mesure ou six registres pour trois axes de mesure. Pour un seul axe de mesure, un premier registre reçoit un premier signal numérique de mesure de la polarisation définie positive du capteur résistif 2, alors qu'un second registre reçoit un second signal numérique de mesure de la polarisation définie négative du capteur résistif 2.

Lors de chaque cycle de mesure, le premier signal numérique et le second signal numérique pour chaque axe stockés dans un registre correspondant, est incrémenté ou décrémenté d'une certaine valeur numérique fonction d'un pas déterminé et programmé. Pour ce faire, l'unité logique 4 comprend un élément de multiplication, qui reçoit le signal de sortie comp_out de l'amplificateur-comparateur 3, et une valeur numérique d'un élément de fourniture d'une valeur de pas. Si la sortie de l'amplificateur-comparateur 3 est à l'état haut "1", cela signifie que la tension Vₘₘ augmente. Dans ces conditions, l'élément de multiplication multiplie la valeur numérique de pas par -1 pour pouvoir soustraire la valeur numérique de pas au précédent signal numérique stocké dans le registre correspondant (dacp, dacn). Par contre si la sortie de l'amplificateur-comparateur 3 est à l'état bas "0", cela signifie que la tension Vₘₘ diminue. Dans ces conditions, l'élément de multiplication multiplie la valeur numérique de pas par +1 pour pouvoir ajouter la valeur numérique de pas au précédent signal numérique stocké dans le registre correspondant.

Au début de chaque conversion, le signal numérique initial fonction de la polarisation positive et de la polarisation négative, correspond au signal numérique mémorisé dans un registre correspondant d'une précédente conversion de mesure. Cependant lors de la mise en fonction du circuit électronique 1, la tension de sortie V_{dac} est de préférence à la moitié de la tension régulée, c'est-à-dire à V_{REG}/2 et se base sur un premier ou second mot binaire initial de l'unité logique 4. Pour les premiers cycles de mesure, l'unité logique 4 est configurée pour commander l'élément de fourniture d'une valeur de pas, afin qu'une petite ou première valeur de pas soit ajoutée ou soustraite du signal numérique d'un registre correspondant dans chaque cycle de mesure en fonction du niveau de la sortie de l'amplificateur-comparateur 3. Cette petite valeur numérique de pas peut avantageusement être choisie pour valoir 1, voire 2 en fonction du bruit à tenir compte.

Après avoir été remis à zéro au début de chaque conversion de mesure, le compteur de décisions compte ou décompte en fonction de l'état du signal de sortie de l'amplificateur-comparateur 3 à chaque cycle de mesure. S'il n'y a qu'une augmentation continuelle ou une diminution continuelle du compteur à chaque premier cycle de mesure successif de la conversion, l'unité logique 4 commande l'élément pour adapter la valeur numérique de chaque pas à une plus grande valeur de pas ou seconde valeur de pas. Cette adaptation intervient dès que le nombre compté successivement de "1" ou de "0" excède un seuil prédéterminé, par exemple après 8, 16, 32 ou un autre nombre de cycles de mesure successifs. Par exemple si après 8 cycles de mesure successifs, il n'y a qu'une augmentation continuelle ou une diminution continuelle du compteur, la valeur de chaque pas à ajouter ou à soustraire à un précédent signal numérique d'un registre correspondant, est augmentée. Cette grande ou seconde valeur de pas peut être programmée de préférence à une valeur égale à 8, mais peut aussi être fixée à une autre valeur, telle que 16, 32, 64 ou une autre grande valeur sur une échelle de 0 à 1023 pour chaque mot binaire sur 10 bits. Cette grande valeur de pas peut également être variable notamment progressivement variable au-dessus de la valeur de 2 ou d'une conversion à une autre conversion. Chaque mot binaire peut être sur plus de 10 bits ou moins de bits en fonction de l'application prévue du circuit électronique à capteur résistif 2.

Une fois que la valeur de pas a été adaptée à une grande valeur, cette grande valeur de pas est ajoutée ou soustraite à un précédent signal numérique du premier ou du second registre dans chaque cycle de mesure successif. Dès qu'un changement de signe du compteur est détecté dans ces cycles de mesure successifs à grande valeur de pas, l'unité logique 4 commande à nouveau l'adaptation de la valeur de pas à une petite valeur et ceci jusqu'au terme de la conversion de mesure. Ceci est effectué pour les 2 registres successivement, voire les 6 registres pour une mesure selon 3 axes. Ainsi une auto-adaptation de la valeur des pas à ajouter ou à soustraire s'opère de manière à tenir compte d'un grand changement du paramètre physique, tel qu'une accélération d'une conversion à une conversion subséquente, ou dans une même conversion de mesure.

Si un grand changement d'accélération intervient dans une même conversion, il se peut qu'une adaptation de la valeur des pas soit nécessaire dans une partie des cycles de mesure finaux de ladite conversion. Cela signifie qu'une réadaptation à une petite valeur dans la conversion peut ne pas survenir et uniquement la valeur finale de chaque signal numérique est prise en compte pour une conversion subséquente.

Pour chaque conversion de mesure, dans laquelle il peut être prévu 16, 32, 40 ou 64 cycles de mesure successifs, une moyenne de tous les signaux numériques successifs stockés dans un registre correspondant une fois que l'unité logique 4 a réadapté la valeur des pas à une petite valeur, peut être effectuée. Si aucune adaptation de la valeur de pas n'est intervenue durant toute la conversion de mesure, quand il n'y a pas de grands changements d'une conversion à une conversion subséquente, la moyenne d'une grande partie finale ou de tous les signaux numériques successifs stockés, peut être effectuée. Au moins 8, 10 ou 12 échantillons dans des cycles de mesure successifs à petits pas, peuvent être en principe nécessaires pour effectuer une moyenne.

La moyenne des signaux numériques successifs, est effectuée par un élément d'exécution d'une moyenne relié aux registres. Plusieurs signaux numériques successifs au terme de la conversion peuvent être stockés également dans l'élément d'exécution d'une moyenne. Cette moyenne n'est effectuée que si aucun changement brusque ne survient dans la phase finale de la conversion de mesure. En cas d'un brusque changement, la valeur de pas est à nouveau adaptée à une plus grande valeur de pas, et une augmentation ou une diminution continuelle à chaque cycle de mesure à grande valeur de pas peut survenir jusqu'au terme de la conversion. Dans ces conditions, uniquement le dernier signal numérique pour un ou plusieurs axes et chaque polarisation est gardé en mémoire pour débuter une nouvelle conversion de mesure.

L'unité logique 4 permet de fournir au moins un signal numérique de sortie OUT au terme d'une conversion de mesure. A ce titre, une combinaison ou addition ou soustraction des deux registres correspondants d'un axe ou de plusieurs axes est effectuée. Il peut être prévu de prendre le mot binaire du premier registre dacp et le mot binaire du second registre dacn et d'effectuer l'opération dacp-dacn pour la fourniture du signal numérique de sortie OUT. Dans ce signal numérique de sortie OUT combiné, tout écart de tension (offset) a été supprimé.

Il est à noter qu'au terme de chaque conversion, soit le dernier signal numérique de chaque registre, soit la moyenne mémorisée de différents signaux numériques au moins dans une partie finale de cycles de mesure, est utilisé pour une nouvelle conversion. Cela permet avantageusement de bénéficier des précédentes variations de valeurs de précédentes conversions tout en mémorisant l'offset précédent. Dans ces conditions, il n'est plus forcément nécessaire d'avoir une adaptation à une grande valeur de pas pour les cycles de mesure pour une conversion subséquente sans changement significatif du paramètre physique à mesurer. Avec les cycles de mesure par l'ajout ou le retrait d'une petite valeur de pas, cela permet avantageusement de réduire les effets du bruit.

La figure 2 montre un schéma simplifié d'une seconde forme d'exécution du circuit électronique 1 à capteur résistif 2 pour une mesure d'un paramètre physique, tel qu'une accélération ou une vitesse angulaire, voire une pression ou une force selon au moins une direction. Etant donné que cette seconde forme d'exécution comprend des éléments identiques à ceux décrits en référence à la figure 1, par simplification, il ne sera expliqué que les différences par rapport à la première forme d'exécution.

Il est prévu pour cette seconde forme d'exécution, un capteur résistif 2 à un seul diviseur résistif pour une mesure selon un axe. Cependant comme précédemment décrit, il peut être envisagé d'avoir un capteur résistif 2 avec trois diviseurs résistifs pour une mesure selon trois axes.

La différence principale de cette seconde forme d'exécution est que la tension de sortie du convertisseur numérique-analogique 5 V_{dac} est fournie directement à la seconde entrée de l'amplificateur-comparateur 3, qui est de préférence l'entrée négative. La première entrée de l'amplificateur-comparateur 3 reste connectée à la masse mobile M et au noeud de connexion des deux résistances R1 et R2 du diviseur résistif.

L'unité de commutation comprend toujours les quatre commutateurs 11, 12, 13, 14, qui peuvent être formés de transistors MOS traditionnels commandés chacun sur leur grille par un signal de commande respectif. Le premier commutateur 11 est disposé entre une source de tension de polarisation Vₚₒₗ et une extrémité libre de la première résistance R1. Le second commutateur 12 est par contre disposé entre une borne de tension basse, par exemple une borne de masse et l'extrémité libre de la première résistance R1. Le troisième commutateur 13 est disposé entre la source de tension de polarisation Vₚₒₗ et une extrémité libre de la seconde résistance R2. Finalement le quatrième commutateur 14 est par contre disposé entre une borne de tension basse, par exemple une borne de masse et l'extrémité libre de la seconde résistance R2.

Comme la tension de sortie V_{dac} est fournie directement à la seconde entrée de l'amplificateur-comparateur 3, il y a une légère différence d'adaptation des signaux numériques suite à la polarisation positive et à la polarisation négative dans l'unité logique 4. Si la tension Vₘₘ est plus grande que la tension V_{dac}, alors le signal de sortie comp_out de l'amplificateur-comparateur 3 est à l'état "1" par exemple proche de la tension régulée V_{REG}. Le mot binaire dacp du premier registre ou le mot binaire dacn du second registre peut être augmenté d'un certain nombre de pas. Par contre si la tension Vₘₘ est plus petite que V_{cm}, alors le signal de sortie comp_out de l'amplificateur-comparateur 3 est à l'état "0". Dans ce cas, le mot binaire dacp du premier registre ou le mot binaire dacn du second registre peut être diminué d'un certain nombre de pas. Au terme de la conversion de mesure la tension Vₘₘ va correspondre à la tension V_{dac}.

Il est à noter que pour cette seconde forme d'exécution du circuit électronique 1, le même algorithme auto-adaptatif pour le procédé de mesure d'un paramètre physique peut être utilisé notamment dans l'unité logique 4.

La figure 3 représente le convertisseur numérique-analogique DAC 5 relié à un générateur de tension de référence à gain programmable 6 pour les première et seconde formes d'exécution du circuit électronique 1. L'unité logique 4 fournit au convertisseur numérique-analogique 5 aussi un mot binaire d'ajustage OFFSET (10 bits) d'un écart de tension relatif au capteur résistif 2 du type MEMS. Un tel convertisseur numérique-analogique 5 relié à un tel générateur de tension de référence à gain programmable 6 est également décrit en détail aux paragraphes 48 et 49 dans la demande de brevet EP 2 618 163 A1, qui est incorporée ici par référence.

Le générateur de tension de référence à gain programmable 6 comprend notamment des diviseurs résistifs R_{H}, R_{B} disposés en série entre la tension régulée V_{REG} et la tension basse V_{SS}, qui est la masse notamment pour la fourniture de la tension en mode commun V_{cm} et la tension de polarisation Vₚₒₗ. Ces diviseurs résistifs sont programmables notamment par un mot binaire TRIM pour ajuster les différents niveaux des tensions à fournir depuis ce générateur de tension de référence à gain programmable 6.

Une tension de référence V_{DACin}, qui provient du générateur de tension de référence à gain programmable 6, est fournie à une première extrémité d'un premier diviseur résistif 15 du convertisseur numérique-analogique 5. Ce premier diviseur résistif 15 peut être programmé par le mot binaire DAC_{bus} provenant du premier registre ou du second registre de l'unité logique 4. Une seconde extrémité du premier diviseur résistif 15 est connectée à une première entrée d'un amplificateur 45 du convertisseur 5. La première entrée de l'amplificateur 45 peut être l'entrée négative.

Une tension d'ajustage V_{OFFin}, qui provient du générateur de tension de référence à gain programmable 6, est fournie à une première extrémité d'un second diviseur résistif 25 du convertisseur numérique-analogique 5. Ce second diviseur résistif 25 peut être programmé par le mot binaire d'ajustage OFFSET provenant de l'unité logique 4. Une seconde extrémité du second diviseur résistif 25 est connectée également à la première entrée de l'amplificateur 45 du convertisseur 5.

Une seconde entrée de l'amplificateur 45 du convertisseur 5 reçoit une tension de référence, correspondant à la tension en mode commun V_{cm} du générateur de tension de référence à gain programmable 6. Cette seconde entrée de l'amplificateur 45 peut être l'entrée positive. Une résistance programmable 35 est encore connectée entre la première entrée de l'amplificateur 45 et une sortie de l'amplificateur, qui fournit la tension de sortie V_{dac}.

A partir de la description qui vient d'être faite, de multiples variantes de réalisation du procédé de mesure d'un paramètre physique et du circuit électronique à capteur résistif pour sa mise en oeuvre peuvent être conçues par l'homme du métier sans sortir du cadre de l'invention définie par les revendications. Il peut être envisagé de modifier la durée de chaque phase l'une par rapport à l'autre ou la durée de chaque cycle durant les opérations de mesure du paramètre physique, ainsi que le nombre de cycles de mesure successifs pour chaque conversion de mesure. La valeur des grands pas dans des cycles de mesure peut être augmentée ou diminuée progressivement dans une même conversion, ou modifiée d'une conversion à une conversion subséquente. Il peut être prévu de modifier l'ordre des polarisations positive et négative dans chaque cycle de mesure. Chaque résistance du capteur résistif peut être un ensemble de résistances unitaires pour apparier les deux résistances du diviseur résistif.

## Revendications

1. Procédé de mesure d'un paramètre physique au moyen d'un circuit électronique (1) à capteur résistif (2), qui comprend un diviseur résistif avec au moins deux résistances (R1, R2) montées en série, dont un noeud de connexion des deux résistances est relié à une masse mobile (M), qui est maintenue élastiquement dans une structure fixe du capteur, et à une première entrée d'un amplificateur-comparateur (3), une seconde entrée de l'amplificateur-comparateur recevant une tension de référence (V_{cm}), une sortie de l'amplificateur-comparateur étant reliée à une unité logique (4) pour un traitement numérique de l'information fournie par l'amplificateur-comparateur et la fourniture d'au moins un signal numérique de sortie (OUT), et un convertisseur numérique-analogique (5) lié à l'unité logique (4) et susceptible de fournir une tension de mesure (V_{dac}) à une extrémité libre de la première résistance (R1) ou à une extrémité libre de la seconde résistance (R2) par l'intermédiaire d'une unité de commutation (11, 12, 13, 14), la tension de mesure étant définie sur la base d'une conversion d'un mot binaire (DAC_{bus}) de l'unité logique (4), qui définit au moins un signal de mesure,
le procédé de mesure étant **caractérisé en ce qu'**il comprend plusieurs cycles successifs de mesure pour une conversion de mesure, où chaque cycle successif de mesure comprend des étapes de :
a) polariser, via l'unité de commutation, l'extrémité libre de la seconde résistance (R2) par une tension de polarisation (Vₚₒₗ) et l'extrémité libre de la première résistance (R1) par une tension de mesure (V_{dac}) fournie par le convertisseur numérique-analogique (5) sur la base d'un premier signal numérique de mesure d'un précédent cycle ou d'un mot binaire initial fourni par l'unité logique (4), le premier signal numérique dépendant d'une première polarisation du capteur résistif,
b) polariser, via l'unité de commutation, l'extrémité libre de la première résistance (R1) par une tension de polarisation (Vₚₒₗ) et l'extrémité libre de la seconde résistance (R2) par une tension de mesure (V_{dac}) fournie par le convertisseur numérique-analogique (5) sur la base d'un second signal numérique de mesure d'un précédent cycle ou d'un mot binaire initial fourni par l'unité logique (4), le second signal numérique dépendant d'une seconde polarisation du capteur résistif.

2. Procédé de mesure d'un paramètre physique au moyen d'un circuit électronique (1) à capteur résistif (2), qui comprend un diviseur résistif avec au moins deux résistances (R1, R2) montées en série, dont un noeud de connexion des deux résistances est relié à une masse mobile (M), qui est maintenue élastiquement dans une structure fixe du capteur, et à une première entrée d'un amplificateur-comparateur (3), une sortie de l'amplificateur-comparateur étant reliée à une unité logique (4) pour un traitement numérique de l'information fournie par l'amplificateur-comparateur et la fourniture d'au moins un signal numérique de sortie (OUT), et un convertisseur numérique-analogique (5) lié à l'unité logique (4) pour fournir une tension de mesure (V_{dac}) à une seconde entrée de l'amplificateur-comparateur (3), la tension de mesure (V_{dac}) étant définie sur la base d'une conversion d'un mot binaire (DAC_{bus}) de l'unité logique (4), qui définit un signal numérique de mesure d'un précédent cycle de mesure ou un mot binaire initial,
le procédé de mesure étant **caractérisé en ce qu'**il comprend plusieurs cycles successifs de mesure pour une conversion de mesure, où chaque cycle successif de mesure comprend des étapes de :
a) polariser, via une unité de commutation (11, 12, 13, 14), une extrémité libre de la seconde résistance (R2) par une tension de polarisation (Vₚₒₗ) et une extrémité libre de la première résistance (R1) par une tension basse (Vss) pour définir une première polarisation du capteur résistif et pour fournir un premier signal numérique de mesure dans l'unité logique,
b) polariser, via l'unité de commutation (11, 12, 13, 14), l'extrémité libre de la première résistance (R1) par une tension de polarisation (Vₚₒₗ) et l'extrémité libre de la seconde résistance (R2) par une tension basse (Vss) pour définir une seconde polarisation du capteur résistif et pour fournir un second signal numérique de mesure dans l'unité logique.

3. Procédé de mesure selon l'une des revendications 1 et 2, pour lequel l'unité logique (4) comprend un premier registre pour mémoriser le premier signal numérique de mesure suite à une première polarisation, définie comme une polarisation positive, et un second registre pour mémoriser le second signal numérique de mesure suite à une seconde polarisation, définie comme une polarisation négative, **caractérisé en ce que** chaque conversion de mesure débute sur la base d'une valeur numérique finale de chaque signal numérique mémorisé dans le premier registre et le second registre d'une précédente conversion ou sur la base d'un mot binaire initial correspondant après conversion par le convertisseur (5) à la moitié d'une tension de régulation d'alimentation du circuit électronique (1).

4. Procédé de mesure selon l'une des revendications 1 et 2, pour lequel le capteur résistif (2) comprend trois diviseurs résistifs composés chacun d'au moins deux résistances (R1, R2) montées en série, et agencés pour une mesure du paramètre physique selon trois directions ou trois axes X, Y, Z, les deux résistances de chaque diviseur ayant un noeud de connexion commun relié à une masse mobile (M) commune et à la même première entrée de l'amplificateur-comparateur (3), **caractérisé en ce que** le procédé comprend six phases successives par cycle de mesure, qui consistent à répéter successivement pendant les trois premières phases, l'étape a) pour chaque axe X, Y, Z avec un premier signal numérique correspondant à l'axe sélectionné, et à répéter successivement pendant les trois dernières phases, l'étape b) pour chaque axe X, Y, Z avec un second signal numérique correspondant à l'axe sélectionné.

5. Procédé de mesure selon l'une des revendications 1 et 2, pour lequel le capteur résistif (2) comprend trois diviseurs résistifs composés chacun d'au moins deux résistances (R1, R2) montées en série, et agencés pour une mesure du paramètre physique selon trois directions ou trois axes X, Y, Z, les deux résistances de chaque diviseur ayant un noeud de connexion commun relié à une masse mobile (M) commune et à la même première entrée de l'amplificateur-comparateur (3), **caractérisé en ce que** le procédé comprend trois conversions successives de mesure selon les trois axes de mesure pour représenter une conversion complète de mesure, où chaque conversion de mesure comprend un certain nombre de cycles de mesure composés successivement des étapes a) et b) avec un premier signal numérique de mesure et un second signal numérique de mesure mémorisés dans l'unité logique (4) et pour chaque axe de mesure correspondant.

6. Procédé de mesure selon l'une des revendications précédentes, **caractérisé en ce que** le procédé utilise un algorithme auto-adaptatif, par lequel chaque conversion de mesure débute par des cycles de mesure, dans lesquels les premier et second signaux numériques pour chaque axe sont adaptés dans l'unité logique (4) par l'addition ou la soustraction d'une première valeur de pas égale à 1 ou 2 en fonction de l'état du signal de sortie de l'amplificateur-comparateur (3) à chaque cycle de mesure, **en ce qu'**un compteur de décisions de l'unité logique (4) compte ou décompte les états successifs de la sortie de l'amplificateur-comparateur (3) à chaque cycle de mesure, pour adapter les premier et second signaux numériques de chaque axe par l'addition ou la soustraction d'une seconde valeur déterminée de pas supérieure à 2, si le nombre compté ou décompté successivement d'états identiques de la sortie l'amplificateur-comparateur (3), excède un seuil prédéterminé, et **en ce qu'**une détection de changement de signe du comptage ou décomptage du compteur de décisions dans les cycles de mesure à la seconde valeur de pas, est contrôlée dans l'unité logique (4), pour réadapter la taille des pas à la première valeur de pas en cas de changement de signe, jusqu'au terme de la conversion de mesure.

7. Procédé de mesure selon la revendication 6, **caractérisé en ce qu'**il est effectué 16, 32, 40 ou 64 cycles de mesure dans chaque conversion de mesure, **en ce que** la première valeur de pas est égale à 1, et **en ce que** la seconde valeur de pas est supérieure ou égale à 8.

8. Circuit électronique (1) à capteur résistif (2) pour la mise en oeuvre du procédé de mesure selon la revendication 1, le capteur résistif (2) comprenant un diviseur résistif avec au moins une première résistance (R1) et une seconde résistance (R2) montées en série, dont un noeud de connexion des deux résistances est relié à une masse mobile (M), qui est maintenue élastiquement dans une structure fixe du capteur, et à une première entrée d'un amplificateur-comparateur (3), une seconde entrée de l'amplificateur-comparateur recevant une tension de référence (V_{cm}), **caractérisé en ce qu'**une sortie de l'amplificateur-comparateur est reliée à une unité logique (4) pour un traitement numérique de l'information fournie par l'amplificateur-comparateur et la fourniture d'au moins un signal numérique de sortie (OUT), et **en ce que** le circuit électronique comprend en outre un convertisseur numérique-analogique (5), lié à l'unité logique (4), et une unité de commutation (11, 12, 13, 14), le convertisseur numérique-analogique (5) est configuré pour fournir une tension de mesure (V_{dac}) à une extrémité libre de la première résistance (R1), alors qu'une extrémité libre de la seconde résistance (R2) est polarisée par une tension de polarisation (Vₚₒₗ), et le convertisseur numérique-analogique (5) est configuré pour fournir la tension de mesure (V_{dac}) à l'extrémité libre de la seconde résistance (R2), alors que l'extrémité libre de la première résistance (R1) est polarisée par la tension de polarisation (Vₚₒₗ), par l'intermédiaire de l' unité de commutation (11, 12, 13, 14), le circuit électronique est configuré de telle sorte, que la tension de mesure étant définie sur la base d'une conversion d'un mot binaire (DAC_{bus}) de l'unité logique (4), qui définit au moins un signal de mesure.

9. Circuit électronique (1) à capteur résistif (2) pour la mise en oeuvre du procédé de mesure selon la revendication 2, le capteur résistif (2) comprenant un diviseur résistif avec au moins une première résistance (R1) et une seconde résistance (R2) montées en série, dont un noeud de connexion des deux résistances est relié à une masse mobile (M), qui est maintenue élastiquement dans une structure fixe du capteur, et à une première entrée d'un amplificateur-comparateur (3), **caractérisé en ce qu'**une sortie de l'amplificateur-comparateur est reliée à une unité logique (4) pour un traitement numérique de l'information fournie par l'amplificateur-comparateur et la fourniture d'au moins un signal numérique de sortie (OUT), **en ce que** le circuit électronique comprend en outre un convertisseur numérique-analogique (5) lié à l'unité logique (4) et configuré pour fournir une tension de mesure (V_{dac}) à une seconde entrée de l'amplificateur-comparateur (3), le circuit électronique est configuré de telle sorte, que la tension de mesure (V_{dac}) étant définie sur la base d'une conversion d'un mot binaire (DAC_{bus}) de l'unité logique (4), qui définit un signal numérique de mesure d'un précédent cycle de mesure ou un mot binaire initial, et **en ce que** le circuit électronique comprend en outre une unité de commutation configuré pour relier une extrémité libre de la seconde résistance (R2) à une tension de polarisation (Vₚₒₗ), alors qu'une extrémité libre de la première résistance (R1) est reliée à une tension basse (Vss), ou inversement.

10. Circuit électronique (1) selon l'une des revendications 8 et 9, **caractérisé en ce que** l'unité logique (4) comprend deux registres pour mémoriser les premier et second signaux numériques de mesure.

11. Circuit électronique (1) selon la revendication 10, **caractérisé en ce que** le capteur résistif (2) comprend trois diviseurs résistifs composés chacun d'au moins une première et seconde résistances (R1, R2) montées en série, et agencés pour une mesure d'un paramètre physique selon trois directions ou trois axes X, Y, Z, les deux résistances de chaque diviseur ayant un noeud de connexion commun relié à une masse mobile (M) commune et à la même première entrée de l'amplificateur-comparateur (3), et **en ce que** l'unité logique (4) comprend six registres pour mémoriser les premier et second signaux numériques de mesure de chaque axe.

12. Circuit électronique (1) selon la revendication 8, **caractérisé en ce que** l'unité de commutation comprend quatre commutateurs (11, 12, 13, 14), qui sont contrôlés par un signal de commande respectif, un premier commutateur (11) étant disposé entre une source de tension de polarisation (Vₚₒₗ) et une extrémité libre de la première résistance (R1), un second commutateur (12) étant disposé entre la sortie du convertisseur analogique-numérique (5) et l'extrémité libre de la première résistance (R1), un troisième commutateur (13) étant disposé entre la source de tension de polarisation (Vₚₒₗ) et une extrémité libre de la seconde résistance (R2), et un quatrième commutateur (14) étant disposé entre la sortie du convertisseur analogique-numérique (5) et l'extrémité libre de la seconde résistance (R2).

13. Circuit électronique (1) selon la revendication 9, **caractérisé en ce que** l'unité de commutation comprend quatre commutateurs (11, 12, 13, 14), qui sont contrôlés par un signal de commande respectif, un premier commutateur (11) étant disposé entre une source de tension de polarisation (Vₚₒₗ) et une extrémité libre de la première résistance (R1), un second commutateur (12) étant disposé entre une borne de tension basse et l'extrémité libre de la première résistance (R1), un troisième commutateur (13) étant disposé entre la source de tension de polarisation (Vₚₒₗ) et une extrémité libre de la seconde résistance (R2), et un quatrième commutateur (14) étant disposé entre la borne de tension basse et l'extrémité libre de la seconde résistance (R2).

14. Circuit électronique (1) selon l'une des revendications 8 et 9, **caractérisé en ce que** la première entrée de l'amplificateur-comparateur (3) est une entrée positive, et **en ce que** la seconde entrée de l'amplificateur-comparateur (3) est une entrée négative.

## Patentansprüche

1. Verfahren zum Messen eines physikalischen Parameters mittels einer elektronischen Schaltung (1) mit Widerstandssensor (2), die umfasst: einen Widerstandsteiler mit mindestens zwei in Reihe geschalteten Widerständen (R1, R2), wobei ein Verbindungsknoten der beiden Widerstände mit einer beweglichen Masse (M), die in einer festen Struktur des Sensors elastisch gehalten ist und mit einem ersten Eingang eines Verstärker-Komparators (3) verbunden ist, ein zweiter Eingang des Verstärker-Komparators eine Referenzspannung (V_{cm}) empfängt und ein Ausgang des Verstärker-Komparators mit einer Logikeinheit (4) verbunden ist, um Informationen, die von dem Verstärker-Komparator geliefert werden, digital zu verarbeiten und um mindestens ein digitales Ausgangssignal (OUT) zu liefern, und einen Digital/Analog-Umsetzer (5), der mit der Logikeinheit (4) verbunden ist und geeignet ist, eine Messspannung (V_{dac}) über eine Umschalteinheit (11, 12, 13, 14) an ein freies Ende des ersten Widerstands (R1) oder an ein freies Ende des zweiten Widerstands (R2) zu liefern, wobei die Messspannung anhand einer Umsetzung eines binären Wortes (DAC_{bus}) der Logikeinheit (4) definiert ist, das mindestens ein Messsignal definiert,
wobei das Messverfahren **dadurch gekennzeichnet ist, dass** es mehrere aufeinanderfolgende Messzyklen für eine Messumsetzung umfasst, wobei jeder aufeinanderfolgende Messzyklus die Schritte umfasst:
a) Vorspannen des freien Endes des zweiten Widerstands (R2) durch eine Vorspannung (Vₚₒₗ) und des freien Endes des ersten Widerstands (R1) durch eine Messspannung (V_{dac}), die von dem Digital/Analog-Umsetzer (5) geliefert wird über die Umschalteinheit auf Grundlage eines ersten digitalen Messsignals eines vorhergehenden Zyklus oder eines anfänglichen von der Logikeinheit (4) gelieferten binären Worts, wobei das erste digitale Signal von einer ersten Vorspannung des Widerstandssensors abhängt,
b) Vorspannen des freien Endes des ersten Widerstands (R1) durch eine Vorspannung (Vₚₒₗ) und des freien Endes des zweiten Widerstands (R2) durch eine Messspannung (V_{dac}), die von dem Digital/Analog-Umsetzer (5) geliefert wird über die Umschalteinheit auf Grundlage eines zweiten digitalen Messsignals eines vorhergehenden Zyklus oder eines anfänglichen von der Logikeinheit (4) gelieferten binären Worts, wobei das zweite digitale Signal von einer zweiten Vorspannung des Widerstandssensors abhängt.

2. Verfahren zum Messen eines physikalischen Parameters mittels einer elektronischen Schaltung (1) mit Widerstandssensor (2), die umfasst: einen Widerstandsteiler mit mindestens zwei in Reihe geschalteten Widerständen (R 1, R2), wobei ein Verbindungsknoten der beiden Widerstände mit einer beweglichen Masse (M), die durch eine feste Struktur des Sensors elastisch gehalten wird, und mit einem ersten Eingang eines Verstärker-Komparators (3) verbunden ist, wobei ein Ausgang des Verstärker-Komparators mit einer Logikeinheit (4) verbunden ist, um Informationen, die von dem Verstärker-Komparator geliefert werden, digital zu verarbeiten und um mindestens ein digitales Ausgangssignal (OUT) zu liefern, und einen Digital/Analog-Umsetzer (5), der mit der Logikeinheit (4) verbunden ist, um an einen zweiten Eingang des Verstärker-Komparators (3) eine Messspannung (V_{dac}) zu liefern, wobei die Messspannung (V_{dac}) auf Grundlage einer Umsetzung eines binären Worts (DAC_{bus}) der Logikeinheit (4) definiert ist, das ein digitales Messsignal eines vorhergehenden Messzyklus oder ein anfängliches binäres Wort definiert,
wobei das Messverfahren **dadurch gekennzeichnet ist, dass** es mehrere aufeinanderfolgende Messzyklen für eine Messumsetzung umfasst, wobei jeder aufeinanderfolgende Messzyklus die Schritte umfasst:
a) Vorspannen eines freien Endes des zweiten Widerstands (R2) durch eine Vorspannung (Vₚₒₗ) und eines freien Endes des ersten Widerstands (R1) durch eine Niederspannung (Vss) über eine Umschalteinheit (11, 12, 13, 14), um eine erste Vorspannung des Widerstandssensors zu definieren und um ein erstes digitales Messsignal an die Logikeinheit zu liefern,
b) Vorspannen des freien Endes des ersten Widerstands (R1) durch eine Vorspannung (Vₚₒₗ) und des freien Endes des zweiten Widerstands (R2) durch eine Niederspannung (Vss) über die Umschalteinheit (11, 12, 13, 14), um eine zweite Vorspannung des Widerstandssensors zu definieren und um ein zweites digitales Messsignal an die Logikeinheit zu liefern.

3. Messverfahren nach einem der Ansprüche 1 und 2, wobei die Logikeinheit (4) ein erstes Register umfasst, um das erste digitale Messsignal nach einem ersten Vorspannen, das als positive Vorspannung definiert ist, zu speichern, und ein zweites Register, um ein zweites digitales Messsignal nach einem zweiten Vorspannen, das als eine negative Vorspannung definiert ist, zu speichern, **dadurch gekennzeichnet, dass** jede Messumsetzung auf Grundlage eines letzten digitalen Werts jedes in dem ersten Register und in dem zweiten Register gespeicherten digitalen Signals einer vorhergehenden Umsetzung oder auf Grundlage eines anfänglichen binären Worts nach der Umsetzung durch den Umsetzer (5), das der Hälfte der Versorgungsregulierungsspannung der elektronischen Schaltung (1) entspricht, beginnt.

4. Messverfahren nach einem der Ansprüche 1 und 2, wobei der Widerstandssensor (2) drei Widerstandsteiler umfasst, die jeweils aus mindestens zwei in Reihe geschalteten Widerständen (R1, R2) zusammengesetzt sind und dafür ausgelegt sind, einen physikalischen Parameter in drei Richtungen oder entlang drei Achsen X, Y, Z zu messen, wobei die beiden Widerstände jedes Teilers einen gemeinsamen Verbindungsknoten besitzen, der mit einer gemeinsamen beweglichen Masse (M) und mit demselben ersten Eingang des Verstärker-Komparators (3) verbunden sind, **dadurch gekennzeichnet, dass** das Verfahren sechs aufeinanderfolgende Phasen pro Messzyklus umfasst, die darin bestehen, nacheinander während der drei ersten Phasen den Schritt a) für jede Achse X, Y, Z mit einem ersten digitalen Signal, das der ausgewählten Achse entspricht, aufeinanderfolgend zu wiederholen und während der drei letzten Phasen den Schritt b) für jede Achse X, Y, Z mit einem zweiten digitalen Signal, das der ausgewählten Achse entspricht, aufeinanderfolgend zu wiederholen.

5. Messverfahren nach einem der Ansprüche 1 und 2, wobei der Widerstandssensor (2) drei Widerstandsteiler umfasst, die jeweils aus mindestens zwei in Reihe geschalteten Widerständen (R1, R2) zusammengesetzt sind und dafür ausgelegt sind, einen physikalischen Parameter in drei Richtungen oder entlang drei Achsen X, Y, Z zu messen, wobei die Widerstände jedes Teilers einen gemeinsamen Verbindungsknoten besitzen, der mit einer gemeinsamen beweglichen Masse (M) und mit demselben ersten Eingang des Verstärker-Komparators (3) verbunden ist, **dadurch gekennzeichnet, dass** das Verfahren drei aufeinanderfolgende Messumsetzungen entlang der drei Messachsen umfasst, um eine vollständige Messumsetzung darzustellen, wobei jede Messumsetzung eine bestimmte Anzahl von aufeinanderfolgend aus den Schritten a) und b) aufgebauten Messzyklen mit einem ersten digitalen Messsignal und einem zweiten digitalen Messsignal, die in der Logikeinheit (4) gespeichert sind, und für jede entsprechende Messachse umfasst.

6. Messverfahren nach einem der vorhergehenden Ansprüche, **dadurch gekennzeichnet, dass** das Verfahren einen selbstanpassenden Algorithmus verwendet, bei dem jede Messumsetzung mit Messzyklen beginnt, in denen das erste und das zweite digitale Signal für jede Achse in der Logikeinheit (4) angepasst werden durch Addition oder Subtraktion eines ersten Schrittwertes, der in Abhängigkeit von dem Zustand des Ausgangssignals des Verstärker-Komparators (3) in jedem Messzyklus gleich 1 oder 2 ist, dass ein Zähler für Entscheidungen der Logikeinheit (4) die aufeinanderfolgenden Zustände des Ausgangs des Verstärker-Komparators (3) bei jedem Messzyklus aufwärts- oder abwärtszählt, um das erste und das zweite digitale Signal jeder Achse durch Addition oder Subtraktion eines zweiten bestimmten Schrittwertes, der größer als 2 ist, anzupassen, falls die aufeinanderfolgend aufwärts- oder abwärtsgezählte Zahl gleicher Zustände des Ausgangs des Verstärker-Komparators (3) einen vorgegebenen Schwellenwert überschreitet, und dass eine Detektion einer Vorzeichenänderung der Aufwärtszählung oder der Abwärtszählung des Entscheidungszählers in den Messzyklen mit dem zweiten Schrittwert in der Logikeinheit (4) überwacht wird, um die Größe der Schritte des ersten Schrittwertes im Fall einer Vorzeichenänderung bis zum Ende der Messumsetzung erneut anzupassen.

7. Messverfahren nach Anspruch 6, **dadurch gekennzeichnet, dass** in jeder Messumsetzung 16, 32, 40 oder 64 Messzyklen ausführt werden, dass der erste Schrittwert gleich 1 ist und dass der zweite Schrittwert größer oder gleich 8 ist.

8. Elektronische Schaltung (1) mit Widerstandssensor (2) für die Ausführung des Messverfahrens nach Anspruch 1, wobei der Widerstandssensor (2) einen Widerstandsteiler mit mindestens einem ersten Widerstand (R1) und einem zweiten Widerstand (R2), die in Reihe geschaltet sind, umfasst, wobei ein Verbindungsknoten der beiden Widerstände mit einer beweglichen Masse (M), die durch eine feste Struktur des Sensors elastisch gehalten ist, und mit einem ersten Eingang eines Verstärker-Komparators (3) verbunden ist, wobei ein zweiter Eingang des Verstärker-Komparators eine Referenzspannung (V_{cm}) empfängt, **dadurch gekennzeichnet, dass** ein Ausgang des Verstärker-Komparators mit einer Logikeinheit (4) verbunden ist, um Informationen, die von dem Verstärker-Komparator geliefert werden, digital zu verarbeiten und um mindestens ein digitales Ausgangssignal (OUT) zu liefern, und dass die elektronische Schaltung ferner einen mit der Logikeinheit (4) verbundenen Digital/Analog-Umsetzer (5) und eine Umschalteinheit (11, 12, 13, 14) umfasst, wobei der Digital/Analog-Umsetzer (5) konfiguriert ist, eine Messspannung (V_{dac}) über die Umschalteinheit (11, 12, 13, 14) an ein freies Ende des ersten Widerstands (R1) zu liefern, während ein freies Ende des zweiten Widerstands (R2) durch eine Vorspannung (Vₚₒₗ) vorgespannt ist, und wobei der Digital/Analog-Umsetzer (5) konfiguriert ist, die Messspannung (V_{dac}) über die Umschalteinheit (11, 12, 13, 14) an das freie Ende des zweiten Widerstands (R2) zu liefern, während das freie Ende des ersten Widerstands (R1) durch die Vorspannung (Vₚₒₗ) vorgespannt ist, wobei die elektronische Schaltung in der Weise konfiguriert ist, dass die Messspannung auf Grundlage einer Umsetzung eines binären Worts (DAC_{bus}) der Logikeinheit (4) definiert ist, das mindestens ein digitales Messsignal definiert.

9. Elektronische Schaltung (1) mit Widerstandssensor (2) für die Ausführung des Messverfahrens nach Anspruch 2, wobei der Widerstandssensor (2) einen Widerstandsteiler mit mindestens einem ersten Widerstand (R1) und einem zweiten Widerstand (R2), die in Reihe geschaltet sind, umfasst, wobei ein Verbindungsknoten der beiden Widerstände mit einer beweglichen Masse (M), die durch eine feste Struktur des Sensors elastisch gehalten ist, und mit einem ersten Eingang eines Verstärker-Komparators (3) verbunden ist, **dadurch gekennzeichnet, dass** ein Ausgang des Verstärker-Komparators mit einer Logikeinheit (4) verbunden ist, um Informationen, die von dem Verstärker-Komparator geliefert werden, digital zu verarbeiten und um mindestens ein digitales Ausgangssignal (OUT) zu liefern, dass die elektronische Schaltung ferner einen Digital/Analog-Umsetzer (5) umfasst, der mit der Logikeinheit (4) verbunden ist und konfiguriert ist, eine Messspannung (V_{dac}) an einen zweiten Eingang des Verstärker-Komparators (3) zu liefern, wobei die elektronische Schaltung in einer Weise konfiguriert ist, dass die Messspannung (V_{dac}) auf Grundlage einer Umsetzung eines binären Worts (DAC_{bus}) der Logikeinheit (4) definiert ist, das ein digitales Messsignal eines vorhergehenden Messzyklus oder ein anfängliches binäres Wort definiert, und dass die elektronische Schaltung ferner eine Umschalteinheit umfasst, die konfiguriert ist, ein freies Ende des zweiten Widerstands (R2) mit einer Vorspannung (Vₚₒₗ) zu verbinden, während ein freies Ende des ersten Widerstand (R1) mit einer Niederspannung (Vss) verbunden ist, oder umgekehrt.

10. Elektronische Schaltung (1) nach einem der Ansprüche 8 und 9, **dadurch gekennzeichnet, dass** die Logikeinheit (4) zwei Register umfasst, um die ersten und zweiten digitalen Messsignale zu speichern.

11. Elektronische Schaltung (1) nach Anspruch 10, **dadurch gekennzeichnet, dass** der Widerstandssensor (2) drei Widerstandsteiler umfasst, die jeweils aus mindestens einem ersten und einem zweiten Widerstand (R1, R2), die in Reihe geschaltet sind, zusammengesetzt sind und dafür ausgelegt sind, einen physikalischen Parameter in drei Richtungen oder entlang drei Achsen X, Y, Z zu messen, wobei die beiden Widerstände jedes Teilers einen gemeinsamen Verbindungsknoten besitzen, der mit einer gemeinsamen beweglichen Masse (M) und mit demselben ersten Eingang des Verstärker-Komparators (3) verbunden ist, und dass die Logikeinheit (4) sechs Register umfasst, um das erste und das zweite digitale Messsignal jeder Achse zu speichern.

12. Elektronische Schaltung (1) nach Anspruch 8, **dadurch gekennzeichnet, dass** die Umschalteinheit vier Schalter (11, 12, 13, 14) umfasst, die durch ein entsprechendes Steuersignal gesteuert werden, wobei ein erster Schalter (11) zwischen einer Vorspannungsquelle (Vₚₒₗ) und einem freien Ende des ersten Widerstands (R1) angeordnet ist, ein zweiter Schalter (12) zwischen dem Ausgang des Digital/Analog-Umsetzers (5) und dem freien Ende des ersten Widerstands (R1) angeordnet ist, ein dritter Schalter (13) zwischen der Vorspannungsquelle (Vₚₒₗ) und einem freien Ende des zweiten Widerstands (R2) angeordnet ist und ein vierter Schalter (14) zwischen dem Ausgang des Digital/Analog-Umsetzers (5) und dem freien Ende des zweiten Widerstands (R2) angeordnet ist.

13. Elektronische Schaltung (1) nach Anspruch 9, **dadurch gekennzeichnet, dass** die Umschalteinheit vier Schalter (11, 12, 13, 14) umfasst, die durch ein entsprechendes Steuersignal gesteuert werden, wobei ein erster Schalter (11) zwischen einer Vorspannungsquelle (Vₚₒₗ) und einem freien Ende des ersten Widerstands (R1) angeordnet ist, ein zweiter Schalter (12) zwischen einem Niederspannungsanschluss und dem freien Ende des ersten Widerstands (R1) angeordnet ist, ein dritter Schalter (13) zwischen der Vorspannungsquelle (Vₚₒₗ) und einem freien Ende des zweiten Widerstands (R2 angeordnet ist und ein vierter Schalter (14) zwischen dem Niederspannungsanschluss und dem freien Ende des zweiten Widerstands (R2) angeordnet ist.

14. Elektronische Schaltung (1) nach einem der Ansprüche 8 und 9, **dadurch gekennzeichnet, dass** der erste Eingang des Verstärker-Komparators (3) ein positiver Eingang ist und dass der zweite Eingang des Verstärker-Komparators (3) ein negativer Eingang ist.

## Claims

1. Method for measuring a physical parameter by means of an electronic circuit (1) with a resistive sensor (2), which includes a resistive divider with at least two resistors (R1, R2) mounted in series, wherein a connection node of the two resistors is connected to a moving mass (M), which is elastically retained in a fixed structure of the sensor, and to a first input of an amplifier-comparator (3), a second input of the amplifier-comparator receiving a reference voltage (V_{cm}), one output of the amplifier-comparator being connected to a logic unit (4) for digital processing of the information provided by the amplifier-comparator and for providing at least one digital output signal (OUT), and a digital-to-analogue converter (5) connected to the logic unit (4) and capable of providing a measurement voltage (V_{dac}) to a free end of the first resistor (R1) or to a free end of the second resistor (R2) via a switching unit (11, 12, 13, 14), the measurement voltage being defined on the basis of a conversion of a binary word (DAC_{bus}) of the logic unit (4), which defines at least one measurement signal,
the measurement method being **characterized in that** the method includes several successive measurement cycles for one measurement conversion, wherein each successive measurement cycle comprises the steps of:
a) polarizing, via the switching unit, the free end of the second resistor (R2) by a polarization voltage (Vₚₒₗ) and the free end of the first resistor (R1) by a measurement voltage (V_{dac}) provided by the digital-to-analogue converter (5) based on a first digital measurement signal from a preceding cycle or from an initial binary word provided by the logic unit (4), the first digital signal depending on a first polarization of the resistive sensor,
b) polarizing, via the switching unit, the free end of the first resistor (R1) by a polarization voltage (Vₚₒₗ) and the free end of the second resistor (R2) by a measurement voltage (V_{dac}) provided by the digital-to-analogue converter (5) based on a second digital measurement signal from a preceding cycle or from an initial binary word provided by the logic unit (4), the second digital signal depending on a second polarization of the resistive sensor.

2. Method for measuring a physical parameter by means of an electronic circuit (1) with a resistive sensor (2), which includes a resistive divider with at least two resistors (R1, R2) mounted in series, wherein a connection node of the two resistors is connected to a moving mass (M), which is elastically retained in a fixed structure of the sensor, and to a first input of an amplifier-comparator (3), one output of the amplifier-comparator being connected to a logic unit (4) for digital processing of the information provided by the amplifier-comparator and for providing at least one digital output signal (OUT), and a digital-to-analogue converter (5) connected to the logic unit (4) to provide a measurement voltage (V_{dac}) to a second input of the amplifier-comparator (3), the measurement voltage (V_{dac}) being defined on the basis of a binary word (DAC_{bus}) of the logic unit (4), which defines a digital measurement signal of a preceding measurement cycle or an initial binary word,
the measurement method being **characterized in that** the method includes several successive measurement cycles for one measurement conversion, wherein each successive measurement cycle comprises the steps of:
a) polarizing, via a switching unit (11, 12, 13, 14), a free end of the second resistor (R2) by a polarization voltage (Vₚₒₗ) and a free end of the first resistor (R1) by a low voltage (Vss) to define a first polarization of the resistive sensor and to provide a first digital measurement signal in the logic unit,
b) polarizing, via the switching unit (11, 12, 13, 14), the free end of the first resistor (R1) by a polarization voltage (Vₚₒₗ) and the free end of the second resistor (R2) by a low voltage (Vss) to define a second polarization of the resistive sensor and to provide a second digital measurement signal in the logic unit.

3. Measurement method according to any of claims 1 and 2, wherein the logic unit (4) includes a first register for storing the first digital measurement signal following a first polarization, defined as a positive polarization, and a second register for storing the second digital measurement signal following a second polarization, defined as a negative polarization, **characterized in that** each measurement conversion starts on the basis of a final numerical value of each digital signal stored in the first register and the second register from a preceding conversion or on the basis of an initial binary word corresponding, after conversion by the converter (5), to half of a regulated supply voltage of the electronic circuit (1).

4. Measurement method according to any of claims 1 and 2, wherein the resistive sensor (2) includes three resistive dividers each composed of at least two resistors (R1, R2) mounted in series, and arranged to measure a physical parameter in three directions or on three axes X, Y, Z, the two resistors of each divider having a common connection node connected to a common moving mass (M) and to the same first input of the amplifier-comparator (3), **characterized in that** the method includes six successive phases per measurement cycle, which consist in successively repeating, during the first three phases, step a) for each axis X, Y, Z with a first digital signal corresponding to the selected axis, and in successively repeating, during the last three phases, step b) for each axis X, Y, Z with a second digital signal corresponding to the selected axis.

5. Measurement method according to any of claims 1 and 2, wherein the resistive sensor (2) includes three resistive dividers each composed of at least two resistors (R1, R2) mounted in series, and arranged to measure a physical parameter in three directions or on three axes X, Y, Z, the two resistors of each divider having a common connection node connected to a common moving mass (M) and to the same first input of the amplifier-comparator (3), **characterized in that** the method includes three successive measurement conversions on the three measurement axes to represent one complete measurement conversion, wherein each measurement conversion includes a certain number of measurement cycles successively composed of steps a) and b) with a first digital measurement signal and a second digital measurement signal stored in the logic unit (4) and for each corresponding measurement axis.

6. Measurement method according to claims 1 and 2, **characterized in that** the method uses a self-adaptive algorithm, wherein each measurement conversion starts with measurement cycles, wherein the first and second digital signals for each axis are adapted in the logic unit (4), by the addition or the subtraction of a first step value equal to 1 or 2 as a function of the state of the output signal of the amplifier-comparator (3) in each measurement cycle, **in that** a decision counter of the logic unit (4) counts or counts down the successive output states of the amplifier-comparator (3) in each measurement cycle, so as to adapt the first and second digital signals of each axis by the addition or the subtraction of a second determined step value higher than 2, if the number of identical output states of the amplifier-comparator (3) successively counted or counted down exceeds a predetermined threshold, and **in that** detection of a change of sign in the count or countdown of the decision counter in the measurement cycles at the second step value, is checked in the logic unit (4) so as to re-adapt the step size to the first step value in the event of a change of sign, until the end of the measurement conversion.

7. Measurement method according to claim 6, **characterized in that** 16, 32, 40 or 64 measurement cycles are performed in each measurement conversion, **in that** the first step value is equal to 1 and **in that** the second step value is greater than or equal to 8.

8. Electronic circuit (1) with a resistive sensor (2) for implementation of the measurement method according to claim 1, the resistive sensor (2) including a resistive divider with at least a first resistor (R1) and a second resistor (R2) mounted in series, wherein a connection node of the two resistors is connected to a moving mass (M), which is elastically retained in a fixed structure of the sensor, and to a first input of an amplifier-comparator (3), a second input of the amplifier-comparator receiving a reference voltage (V_{cm}), **characterized in that** one output of the amplifier-comparator is connected to a logic unit (4) for digital processing of the information provided by the amplifier-comparator and for providing at least one digital output signal (OUT), and **in that** the electronic circuit further includes a digital-to-analogue converter (5) connected to a logic unit (4), and a switching unit (11, 12, 13, 14), the digital-to-analogue converter (5) being configured to provide a measurement voltage (V_{dac}) to a free end of the first resistor (R1), whereas a free end of the second resistor (R2) is polarized by a polarization voltage (Vₚₒₗ), and the digital-to-analogue converter (5) being configured to provide the measurement voltage (V_{dac}) to the free end of the second resistor (R2), whereas the free end of the first resistor (R1) is polarized by the polarization voltage (Vₚₒₗ), via the switching unit (11, 12, 13, 14), the electronic circuit being configured so that the measurement voltage is defined on the basis of a conversion of a binary word (DAC_{bus}) of the logic unit (4), which defines at least one measurement signal.

9. Electronic circuit (1) with a resistive sensor (2) for implementation of the measurement method according to claim 2, the resistive sensor (2) including a resistive divider with at least a first resistor (R1) and a second resistor (R2) mounted in series, wherein a connection node of the two resistors is connected to a moving mass (M), which is elastically retained in a fixed structure of the sensor, and to a first input of an amplifier-comparator (3), **characterized in that** one output of the amplifier-comparator is connected to a logic unit (4) for digital processing of the information provided by the amplifier-comparator and for providing at least one digital output signal (OUT), **in that** the electronic circuit further includes a digital-to-analogue converter (5) connected to the logic unit (4) and configured to provide a measurement voltage (V_{dac}) to a second input of the amplifier-comparator (3), the electronic circuit being configured so that the measurement voltage (V_{dac}) is defined on the basis of a binary word (DAC_{bus}) of the logic unit (4), which defines a digital measurement signal of a preceding measurement cycle or an initial binary word, and **in that** the electronic circuit further includes a switching unit configured to connect a free end of the second resistor (R2) to a polarization voltage (Vₚₒₗ) whereas a free end of the first resistor (R1) is connected to a low voltage (Vss) or vice versa.

10. Electronic circuit (1) according to any of claims 8 and 9, **characterized in that** the logic unit (4) includes two registers for storing the first and second digital measurement signals.

11. Electronic circuit (1) according to claim 10, **characterized in that** the resistive sensor (2) includes three resistive dividers each composed of at least a first and a second resistors (R1, R2) mounted in series and arranged for measurement of a physical parameter in three directions or on three axes X, Y, Z, the two resistors of each divider having a common connection node connected to a common moving mass (M) and to the same first input of the amplifier-comparator (3), and **in that** the logic unit (4) includes six registers for storing the first and second digital measurement signals of each axis.

12. Electronic circuit (1) according to claim 8, **characterized in that** the switching unit includes four switches (11, 12, 13, 14), which are controlled by a respective control signal, a first switch (11) being disposed between a polarization voltage source (Vₚₒₗ) and a free end of the first resistor (R1), a second switch (12) being disposed between the output of the analogue-to-digital converter (5) and the free end of the first resistor (R1), a third switch (13) being disposed between the polarization voltage source (Vₚₒₗ) and a free end of the second resistor (R2) and a fourth switch (14) being disposed between the output of the analogue-to-digital converter (5) and the free end of the second resistor (R2).

13. Electronic circuit (1) according to claim 9, **characterized in that** the switching unit includes four switches (11, 12, 13, 14), which are controlled by a respective control signal, a first switch (11) being disposed between a polarization voltage source (Vₚₒₗ) and a free end of the first resistor (R1), a second switch (12) being disposed between a low voltage terminal and the free end of the first resistor (R1), a third switch (13) being disposed between the polarization voltage source (Vₚₒₗ) and a free end of the second resistor (R2) and a fourth switch (14) being disposed between the low voltage terminal and the free end of the second resistor (R2).

14. Electronic circuit (1) according to any of claims 8 and 9, **characterized in that** the first input of the amplifier-comparator (3) is a positive input, and **in that** the second input of the amplifier-comparator (3) is a negative input.
